Europäisches Patentamt

European Patent Office

Office européen des brevets

(11) Veröffentlichungsnummer: **0 479 265 A2**

(12) **EUROPÄISCHE PATENTANMELDUNG**

(21) Anmeldenummer: **91116807.8**

(22) Anmeldetag: **02.10.91**

(51) Int. Cl.5: **H03K 23/66**

(30) Priorität: **05.10.90 DE 4031532**

(43) Veröffentlichungstag der Anmeldung: **08.04.92 Patentblatt 92/15**

(84) Benannte Vertragsstaaten: **CH DE FR GB IT LI NL**

(71) Anmelder: **D.I.E.N.E.S. APPARATEBAU GMBH Philipp-Reis-Strasse 16 W-6052 Mühlheim am Main(DE)**

(72) Erfinder: **Lehle, Erhard Marktstrasse 2 W-6052 Mühlheim am Main(DE)**

(74) Vertreter: **Rentzsch, Heinz Schönbornring 1 W-6078 Neu-Isenburg 2(DE)**

(54) **Steuerbarer Frequenzgenerator.**

(57) Ein steuerbarer Frequenzgenerator weist eine Impulsquelle (OSC), einen nachgeschalteten digitalen Frequenzteiler (TL) sowie eine zwischengeschaltete Torschaltung (TR) auf. Die Ausgangsimpulsfolge $f_A$ des Frequenzteilers (TL) gelangt an einen den Verbraucher speisenden Umrichter sowie an einen Eingang eines Pulsraten-Multiplizierers (PRM), dessen Ausgang mit dem Steuereingang der Torschaltung (TL) in Verbindung steht. Jeder Ausgangsimpuls sperrt die Torschaltung jeweils für die Dauer eines Taktimpulses der Impulsquelle. Ein Rechner (R) führt einerseits dem Steuereingang (STL) des Frequenzteilers (TL) ein dem gewünschten Teilerfaktor entsprechendes Steuerwort und andererseits dem Steuereingang SPRM) des Pulsraten-Multiplizierers (PRM) ein die Unterdrückung von bestimmten Impulsen bewirkendes Steuerwort zu. Die Frequenz der Ausgangsimpulsfolge $f_A$ ist so gewählt, daß jede Halbwelle des Verbraucherstroms aus der gleichen ganzzahligen Anzahl von Impulsen zusammengesetzt ist.

Die Erfindung betrifft einen steuerbaren Frequenzgenerator gemäß Gattungsbegriff des Anspruchs 1, wie er aus der unten erläuterten DE-A 26 39 326 bekannt ist.

Moderne Frequenzumrichter benötigen zur Erzeugung einer bestimmten Ausgangsfrequenz eine um ein Vielfaches, beispielsweise um den Faktor T, höhere Taktfrequenz, weil die Vollwelle der zu erzeugenden Sinusspannung in T Schritte unterteilt und jedem Schritt ein entsprechend der Sinusfunktion ausgewählter Gewichtungsfaktor zugeordnet wird. Dieser kann einem Speicher entnommen oder fortlaufend errechnet werden. Um eine gute Sinus-Kurvenform zu erhalten, hat sich ein Faktor T = 256 als Kompromiß bewährt. Zur Erzeugung von 3-Phasen-Drehstrom entsteht bei der dann notwendigen Teilung der internen Taktfrequenz durch drei nur noch ein geringer Teilungsfehler. Bei der Gleichlaufregelung mehrerer Motoren, beispielsweise in Textilmaschinen, werden sehr feinstufige übersetzungsverhältnisse gefordert, wobei der Gleichlauf nicht nur im Bereich der Solldrehzahlen sondern auch beim Anfahren und beim Stillsetzen der Maschine gewährleistet sein muß.

Aus DE-AS 29 09 018 ist ein Frequenzwandler mit einem steuerbaren Impulsgeber bekannt. Er dient der Synchronisierung eines zweiten Motors mit der Drehzahl eines ersten Motors. An den Impulsgeben ist ein das Verhältnis Ausgangs/Eingangsfrequenz bestimmender Rückführungs-Frequenzteiler angeschlossen, dem der eine Eingang eines Differenzzählers nachgeschaltet ist. Dem zweiten Eingang wird die Eingangsfrequenz zugeführt, und der Zählerstand dient als Steuergröße für den Impulsgeber. Der Taktgeber des Impulsgebers hat eine Frequenz, die größer ist als die höchste geforderte Ausgangsfrequenz des Wandlers, und an den Taktgeber ist ein programmierbarer Frequenzteiler angeschlossen, der vom Differenzzähler gesteuert wird. Dieser Frequenzteiler blendet aus der Impulsfolge des frequenzkonstanten Taktgebers eine durch den Stand des Differenzzählers bestimmte Anzahl von Impulsen aus. Um die sich hierdurch ergebenden Unterschiede in den zeitlichen Abständen der Impulse am Ausgang des Teilers zu beseitigen, wird dem programmierbaren Frequenzteiler ein Frequenzteiler mit konstantem Teilerverhältnis nachgeschaltet, der die Impulsabstände mittelt, so daß seine Ausgangsimpuls praktisch in gleichen zeitlichen Abständen auftreten.

In der DE-C 30 11 967 ist ein Betriebsverfahren für einen Impulsfrequenzteiler mit veränderbarem Teilungsverhältnis beschrieben, der einen Pulsraten-Multiplizierer enthält, dem zum Ausgleich von Frequenzsprüngen seiner Ausgangsimpulse ein Flip-Flop-Kettenteiler nachgeschaltet ist. Dabei wird aus dem Pulsraten-Multiplizierer immer dann eine Flip-Flop-Stufe abgeschaltet und dem Kettenteiler eine Flip-Flop-Stufe zugeschaltet, wenn die gewählte Frequenz der Ausgangsimpulse eine Potenz von 2 unterschreitet.

Weiterhin zeigt die DE-A 26 39 326 einen Frequenz-Synthesizer zur Erzeugung eines beliebigen rationalen Bruchteils einer vorgegebenen Bezugsfrequenz durch Ableitung einer bestimmten Anzahl von Impulsen aus einer vorgegebenen Anzahl von Impulsen der Bezugsfrequenz, wobei eine Impulsverzögerungseinrichtung die abgeleiteten Impulse zeitlich derart verschiebt, daß sie untereinander im wesentlichen gleichmäßige Abstände erhalten. Zu diesem Zweck gelangt die Impulsfolge eines frequenzkonstanten Taktoszillators über eine Torschaltung an einen Modulo-N-Zähler, dessen Ausgangssignal einem programmierbaren Verzögerungsgenerator zugeführt wird. Sein Ausgangssignal bildet das Ausgangssignal des Frequenz-Synthesizers. Wird die Torschaltung aktiviert, so verhindert sie, daß ein ihr am Eingang zugeführter Impuls am Ausgang erscheint. Ist die Torschaltung inaktiv, so läuft der Eingangsimpuls durch die Torschaltung hindurch zum Modulo-N-Zähler. Letzterer liefert jeweils einen Ausgangsimpuls nach N zugeführten Eingangsimpulsen, wobei N wählbar ist. Der programmierbare Verzögerungsgenerator kann einen an seinem Eingang auftretenden Impuls bis zu einer Periodendauer der Taktfrequenz verzögern. Der jeweilige Verzögerungswert wird durch ein Steuerwort bestimmt, welches von einem Akkumulator erzeugt wird. Ein digitaler Teiler berechnet das Verhältnis der Bezugsfrequenz $f_R$ zur gewünschten Ausgangsfrequenz $f_O$ im Format $f_R/f_O$ = n,x ,wobei n die Ganzzahlkomponente des Teilerverhältnisses und x der Bruchanteil (Rest) dieses Verhältnisses ist. Der Ganzzahlanteil n wird dem Modulo-N-Zähler als Steuerwort zugeführt, um dessen Teilerfaktor einzustellen. Die Bruchteilkomponente x gelangt zum Akkumulator und dient als Inkrement für den Akkumulator. Nach Empfang eines Taktsignals addiert der Akkumulator zu seinem bestehenden Inhalt das jeweilige Inkrement und erzeugt eine neue Ausgangszahl, welche den programmierbaren Verzögerungsgenerator steuert. Ein überlaufsignal wird vom Akkumulator während jeder Taktperiode erzeugt, in welcher der Summenwert die Kapazität des Akkumulators übersteigt. Das Ausgangssignal des programmierbaren Verzögerungsgenerators dient sowohl als Ausgangssignal des Frequenz-Synthesizers als auch als Taktsignal für den Akkumulator. Das überlaufsignal des Akkumulators wird der Torschaltung als Aktivierungssignal zugeleitet, so daß bei dessen Auftreten jeweils ein Impuls des Oszillators unterdrückt wird. Der Modulo-N-Zähler und die Torschaltung steuern die mittlere Ausgangsfrequenz des Synthesizers durch Herabdividieren der Oszillatorfrequenz auf die ausgewählte niedrigere Ausgangsfrequenz. Der programmierbare Verzögerungsgenerator verzögert einzelne Impulse um berechnete Zeitspannen so daß der Abstand zwischen den einzelnen Ausgangsimpulsen der gewählten mittleren Ausgangsfrequenz vergleichmäßigt wird.

Ausgehend vom Stand der Technik gemäß DE-A 26 39 326 liegt der Erfindung die Aufgabe zugrunde, den Schaltungsaufbau eines solchen steuerbaren Frequenzgenerators, insbesondere durch den Einsatz handelsüblicher Schaltungsbausteine zu vereinfachen und die Vergleichmäßigung des Impulsabstands im herabgeteilten Ausgangssignal zu verbessern. Dies gelingt durch die in den Patentansprüchen gekennzeichnete Erfindung. Sie erzeugt mit Hilfe eines handelsüblichen Umrichters eine von einem Gleichstromanteil freie Sinusspannung. Diese Gleichstromfreiheit der Speisewechselspannung für den zu steuernden Verbraucher, z.B. einen Motor, ist wichtig, um die zum Drehmoment des Motors nichts beitragende Gleichstromverlustleistung zu minimieren.

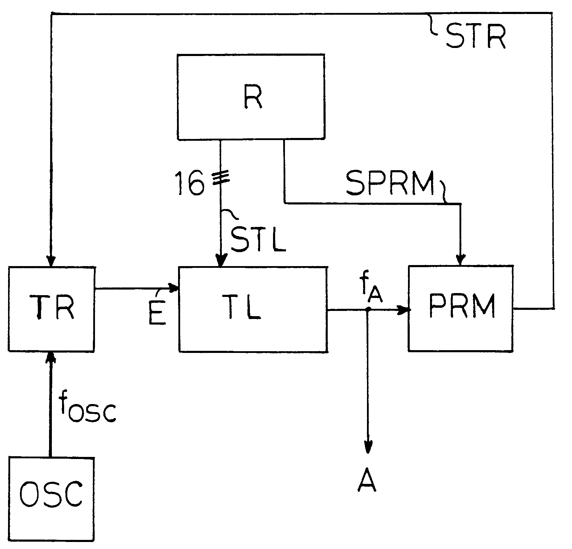

Die Erfindung wird nachfolgend anhand eines in der Zeichnung wiedergegebenen Ausführungsbeispiels erläutert.

Das Ausgangssignal $f_{OSC}$ eines frequenzkonstanten Taktgenerators OSC von beispielsweise 10MHz wird dem ersten Eingang einer Torschaltung TR zugeleitet, deren Ausgang mit dem Signaleingang E eines Teilerbausteins TL, z.B. vom Typ 8254, in Verbindung steht. Dessen Ausgangssignal $f_A$ steht am Ausgang A zur Verfügung und gelangt im Falle einer Motorsteuerung beispielsweise zum Steuereingang eines den Motor speisenden Umrichters. Der veränderbare Teilerfaktor des digitalen Frequenzteilers TL beträgt beispielsweise 1 bis $2^{16}$,

Der Ausgang des Frequenzteilers TL ist ferner an den Signaleingang eines Pulsraten-Multiplizierers PRM angeschlossen, dessen Ausgangssignal über die Steuerleitung STR die oben erwähnte Torschaltung TR steuert. Erscheint am Ausgang des Pulsraten-Multiplizierers PRM ein Impuls, so bewirkt dieser, daß die Torschaltung TR den nächsten an ihrem Signaleingang eintreffenden Taktimpuls unterdrückt. Dies hat eine Dehnung der Dauer bis zum nächsten Ausgangsimpuls der Torschaltung um die Länge einer Periode der Taktfrequenz $f_{OSC}$, d.h. um $1/f_{OSC}$ zur Folge. Abhängig von einem dem Pulsraten-Multiplizierer PRM über eine 8- bzw. 7-adrige Steuerleitung SPRM zugeführten Steuerwort können beliebige, sich wiederholende Dehnungsmuster, d.h. Ausblendungen eines oder mehrerer Impulse erzeugt werden.

Die Torschaltung TR enthält beispielsweise einen Speicher, der beim Eintreffen eines Impulses auf der Steuerleitung STR gesetzt wird und den Zähleingang E des Teilers TL sperrt. Der nächste Taktimpuls wird folglich unterdrückt und gelangt nicht zum Eingang E des Teilers TL.. Der darauffolgende Taktimpuls am Eingang der Torschaltung TR setzt den Speicher wieder zurück, so daß die Torschaltung wieder durchgeschaltet wird und dieser Taktimpuls am Zähleingang E des Teilers TL wirksam ist. Der Teilerfaktor des Teilers TL wird diesem vom Rechner R über die Steuerleitungen STL eingegeben.

Ein Zahlenbeispiel soll nachfolgend die Vergleichmäßigung des Ausgangssignals durch die erfindungsgemäße Schaltungsanordnung verdeutlichen. Angenommen sei, daß zur Erzeugung einer Sinusperiode 256 Impulse benutzt werden. Wird eine Motorfrequenz von 200Hz benötigt, so muß der Teiler TL eine Ausgangsfrequenz $f_A$ von 200Hz x 256 = 51200Hz liefern. Verwendet man einen steuerbaren Teiler TL vom Typ 8254 und einen Taktgeber OSC mit einer Taktfrequenz $f_{OSC}$ von 10MHz, so ergibt sich ein Teilerfaktor von 10 000 000 : 51 200 = 195,3125. Die nächste ganze Zahl ist 195. Die mit dem Teilerfaktor 195 erzeugte Motorfrequenz beträgt demnach 10 000 000 : 195 : 256 = 200,3205Hz. Die nächstmögliche Frequenz ergibt sich aus dem Teilerfaktor 194 zu 10 000 000 : 194 : 256 = 201,3531Hz. Dies ist ein Frequenzsprung von etwa 0,5%, der bei zahlreichen Anwendungen zu groß ist. Durch die erfindungsgemäße Dehnung des Zeitabstands zwischen den Eingangsimpulsen für den Teiler TL mit Hilfe des Pulsraten-Multiplizierers PRM um den Faktor $1/f_{OSC}$, d.h. im vorliegenden Fall um 0,1µsec, wird der Frequenzsprung, der aufgrund eines Inkrements des Teilerfaktors des Teilers TL entsteht, auf 1/256 reduziert. Dies sind im genannten Beispiel weniger als 1/200Hz.

Das Dehnungsmuster wiederholt sich in jeder Vollwelle der sinusbewerteten Motorfreuenz. Wird das geringstwertige Bit LSB zu Null, so wiederholt es sich in jeder Halbwelle zu erzeugenden Sinusspannung, d.h.im Abstand von 128 Taktimpulsen, so daß weder ein Phasenjitter noch eine Unsymmetrie zwischen der positiven und der negativen Motorhalbwellen entsteht.

Ein weiterer Vorteil liegt in der einfachen Steuerung des Pulsraten-MultiplizierersPRM durch ein Software-Steuerwort auf den Leitungen SPRM. Das anzulegende Steuerwort ist einfach der 8-Bit-Rest aus der Divisionsroutine, die den ganzzahligen Teilerwert für den Teilerfaktor des Teilers TL ermittelt hat. Das geringstwertige Bit LSB wird auf Null abgerundet. Dies folgt aus nachstehendeer Rechnung, in welcher

| | | |
|---|---|---|
| $f_{SOLL}$ = | gewünschte Sollfrequenz | |
| $f_{OSC}$ = | Taktfrequenz | |
| F = | ganzzahliger Teilerfaktor | |
| R = | Bruchteilsrest | |
| $N_A$ = | Sollzahl der Eingangsimpulse am Eingang E des Teilers TL/Periode | |

$N_B$ = Istzahl dieser Impulse/Periode ohne Rest

$f_{SOLL}$ = $f_{OSC}$ : F,R

$N_A$ = 256 x F,R

$N_B$ = 256 x F,0

Das sind zuviele Impulse, nämlich $N_A$ - $N_B$ = 256 x F,R - 256 x F,0 = 256 x 0,R

Dies ist die Anzahl der zu unterdrückenden Taktimpulse pro Vollwelle der Sinusschwingung. Diese Anzahl wird, vom Bitratenmultiplizierer gesteuert, unterdrückt. Umrichter mit anderen Sollfrequenzanforderungen können in der gleiche Weise angesteuert werden. Der Bitratenmultiplizierer wird nach einer vorgegebenen Anzahl von Taktimpulsen zurückgesetzt, und der Restwert wird in der Divisionsroutine umgerechnet.

Die Erfindung ist keineswegs auf Frequenzgeneratoren für Umrichter in Motorsteuerungen beschränkt. Sie kann mit gleich Vorteilen beispielsweise auch für Frequenzteilerschaltungen in elektronischen Musikinstrumenten, für die Koordinatenkoordination bei Robotersteuerungen und anderen eine große Dynamik erfordernden Frequenzgeneratoren eingesetzt werden, bei denen die vom Umrichter erzeugte Wechselspannung möglichst gleichstromfrei sein soll. In Textilmaschinen gewährleistet sie ein konstantes Streckverhältnis der Fäden, Folien oder Garne und erleichtert das Anfahren der Maschine. Bei diesen Anwendungen wird eine Impulsquelle mit konstanter Ausgangsfrequenz benutzt. Die Erfindung kann jedoch auch zur Ableitung einer zweiten Impulsfolge mit vorgegebenem Teilerverhältnis aus einer ersten Impulsfolge benutzt werden, wenn sich die Frequenz der ersten Impulsfolge ändert. Dies ist beispielsweise der Fall, wenn ein zweiter, langsam laufender Motor mit einem ersten, schnellaufenden Motor synchronisiert werden soll.

**Patentansprüche**

1. Steuerbarer Frequenzgenerator mit
   a) einer Impulsquelle (OSC) zur Erzeugung einer Impulsfolge;
   b) einem nachgeschalteten steuerbaren digitalen Frequenzteiler (TL); sowie
   c) einer zwischen Impulsquelle und Signaleingang (E) des Frequenzteilers eingeschalteten Torschaltung (TR);
   **dadurch gekennzeichnet,** daß
   d) die am Ausgang (A) des Frequenzteilers stehende Impulsfolge ($f_A$) einem Umrichter zugeführt wird, welcher einen sinusförmigen Speisestrom für einen Verbraucher, z.B. einen Motor, erzeugt;
   e) an den Ausgang des Frequenzteilers (TL) andererseits der Signaleingang eines Pulsraten-Multiplizierers (PRM) angeschlossen ist;
   f) der Ausgang des Pulsraten-Multiplizierers mit dem Steuereingang der Torschaltung (TR) in Verbindung steht und jeder Ausgangsimpuls des Pulsraten-Multiplizierers die Torschaltung für jeweils einen Impuls der Impulsquelle (OSC) sperrt;
   g) ein Rechner (R) einerseits dem Steuereingang (STL) des Frequenzteilers ein dem gewünschten Teilerfaktor entsprechendes Steuerwort und andererseits dem Steuereingang (SPRM) des Pulsraten-Multiplizierers (PRM) ein die Unterdrückung von bestimmten Impulsen bewirkendes Steuerwort zuführt; und
   h) die Frequenz ($f_A$) der Ausgangsimpulsfolge so gewählt ist, daß jede Halbwelle des Verbraucherstroms aus der gleichen ganzzahligen Anzahl von Impulsen zusammengesetzt ist.

2. Frequenzgenerator nach Anspruch 1, dadurch gekennzeichnet, daß die Impulsquelle eine konstante Impulsfolgefrequenz liefert.

3. Frequenzgenerator nach Anspruch 1, dadurch gekennzeichnet, daß die Impulsquelle eine der Drehzahl eines Leitantriebs entsprechende Impulsfolgefrequenz liefert.

4. Frequenzgenerator nach einem der vorangehenden Ansprüche, dadurch gekennzeichnet, daß das Steuerwort für den Pulsraten-Multiplizierer (PRM) durch den Bruchteilsrest aus der den Teilerfaktor für den Frequenzteiler (TL) ermittelnden Division gebildet ist.